(19) Europäisches Patentamt
European Patent Office
Office européen des brevets

(11) **EP 2 765 430 A1**

(12) **EUROPEAN PATENT APPLICATION**
published in accordance with Art. 153(4) EPC

(43) Date of publication:
**13.08.2014 Bulletin 2014/33**

(51) Int Cl.:
*G01R 31/08* (2006.01)   *G01R 27/04* (2006.01)
*G01R 27/32* (2006.01)

(21) Application number: **12834402.5**

(22) Date of filing: **19.09.2012**

(86) International application number:
**PCT/KR2012/007475**

(87) International publication number:
**WO 2013/042925 (28.03.2013 Gazette 2013/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.09.2011 KR 20110094725**

(71) Applicants:
• **Yousung Instrument & Electric Co.,Ltd**
  **Incheon 405-822 (KR)**
• **Kim, Il Dong**
  **Anseong-si, Gyeonggi-do 456-893 (KR)**

(72) Inventors:
• **KIM, Il Dong**
  **Anseong-si, Gyeonggi-do 456-893 (KR)**
• **LEE, Jin Rak**
  **Bucheon-si**
  **Gyeonggi-do 420-708 (KR)**

(74) Representative: **Liedl, Christine et al**
  **Hansmann & Vogeser**
  **Patent- und Rechtsanwälte**
  **Maximilianstrasse 4b**
  **82319 Starnberg (DE)**

(54) **SYSTEM AND METHOD FOR MONITORING POWER FACILITY STATUS BY MEASURING ONLINE ELECTRIC CIRCUIT PARAMETER**

(57)     The present invention relates to a system and a method for monitoring a power facility by measuring from online a line parameter of the power facility that is in operation, and the system for monitoring the power facility, according to the present invention, sets a measurement time and selects a facility to be measured in accordance with external input, receives current and voltage data which are measured from the facility to be measured, extracts the current and voltage data that are simultaneously measured at the measurement time that is set, by referencing time information that is tagged on the current and voltage data that are inputted, removes zero-phase-sequence component from the current and voltage data, outputs the line parameter with respect to the facility to be measured that is selected by using the current and voltage data from which the zero-phase-sequence component is removed, determines the electrical status of the facility including malfunction and various connection statuses depending on whether the size or the increase/decrease rate of the line parameter that is outputted is beyond a predetermined standard value to output a status notification message or a trip signal, thereby monitoring/controlling the status of the facility to be measured.

Fig. 1

**Description**

**TECHNICAL FIELD**

The present invention relates to a system and method for monitoring a state of a power facility by measuring electric circuit parameters on-line, which can correctly diagnose and monitor a state of an operating power facility by measuring and monitoring line parameters (resistance R, inductance L, capacitance C, and leakage conductance g) of the power facility on-line.

**BACKGROUND ART**

A change in a state of a power facility is expressed as changes in line parameters (resistance R, inductance L, capacitance C, and leakage conductance g). However, since there is no way for measuring the line parameters of an operating power facility until now, a state of the power facility is estimated and used by attaching a plurality of sensors to the power facility and sensing changes in temperature, pressure and vibration, a partial discharge phenomenon and the like, which are secondary physical phenomena generated from the changes in the line parameters of the facility.
In the case of a method using sensors, there may be an area in which an abnormal state cannot be measured depending on positions, quantities and distribution of installed sensors. For example, when the abnormal state is sensed by temperature, since the temperature is not measured from all parts of the facility, but only excessive heat or a change in temperature is detected at portions where temperature sensors are installed, there is an area in which an abnormal state cannot be sensed.
In addition, since there is a time delay until the secondary physical phenomena generated by the changes in the power facility itself are appeared, there is a limit to some extent in monitoring an abnormal state of the facility, and, particularly, in the case of a transmission line installed across a wide area, a plurality of sensors is installed, and thus it is impractical since there are a lot of difficulties in maintenance.
Furthermore, until now, there is no technique for monitoring on-line connections of circuit breakers, switches or the like connecting various connection parts of the power facility itself to various facilities, bad states of contacting parts, disconnections of wires in an old facility or the like, and measuring and monitoring on-line changes in leakage conductance and capacitance which show an insulation state of the facility. However, these phenomena can be measured at all times by the present invention.

**DISCLOSURE OF INVENTION**

**TECHNICAL PROBLEM**

Therefore, the present invention has been made in view of the above problems, and it is an object of the present invention to provide a system and method for monitoring a state of a power facility by measuring electric circuit parameters on-line, which can measure line parameters (resistance R, inductance L, capacitance C, and leakage conductance g), which are unique physical quantities of its own, existing in the power facility while operating the power facility and monitor a state of the power facility (a connection state and an insulation state) based on the measured values.

**TECHNICAL SOLUTION**

To accomplish the above object, according to one aspect of the present invention, there is provided a system for monitoring a state of a power facility using line parameters, the system comprising: a measurement device including an analog-to-digital (A/D) converter for simultaneously sampling and converting current and voltage of the power facility measured through a current transformer (CT) and a potential transformer (PT) into digital signals by synchronizing the current and voltage to a time synchronization signal, a global positioning system (GPS) module for providing the A/D converter with the time synchronization signal, and a communication module for transmitting the current and voltage signals output from the A/D converter through Ethernet; a power facility state monitoring device including an input unit for inputting measurement data transmitted through the communication module, an operation unit for calculating line parameters of a monitored target power facility using the measurement data input through the input unit, a communication unit for transmitting the calculated line parameters according to a certain communication specification, and a monitor and control unit for monitoring and controlling the power facility by controlling operation of each of the constitutional components described above, determining existence of an abnormal state according to whether or not a magnitude or an increase or decrease rate of the calculated line parameters goes out of a predetermined reference value, and outputting an alarm, a state alarm message or a trip. signal; and a human machine interface (HMI) for estimating a state of the power facility using the line parameters provided from the power facility state monitoring device.

According to another aspect of the present invention, there is provided a method of monitoring a state of a power facility by measuring line parameters, the method comprising the steps of setting a measurement time and selecting a measurement target facility according to an external input; inputting current and voltage data measured at the selected measurement target facility; extracting current and voltage data corresponding to the set measurement time with reference to time information tagged on the input current and voltage data; removing an zero-phase-sequence component from the extracted current and voltage data; calculating the line parameters of the selected measurement target facility using the current and voltage data from which the zero-phase-sequence component is removed; and determining existence of abnormality of the power facility according to whether or not an increase or decrease rate or magnitude of absolute values of the calculated line parameters goes out of a predetermined reference value, and outputting an alarm, a state alarm message or a trip signal.

## ADVANTAGEOUS EFFECTS

Accordingly, since occurrence of an abnormal state in a power facility is a change in an electric circuit parameter (R, L, C or g) which is a primary physical phenomenon, the present invention may correctly monitor a state of the power facility by measuring and monitoring the parameters.

The present invention may diagnose a state of a power facility and grasp abnormality of the power facility by simultaneously measuring input and output voltage and current at both ends of the power facility, receiving the input and output data through a communication means or the like used for a smart grid, calculating electrical line parameters of the power facility and constantly monitoring the line parameters.

## BRIEF DESCRIPTION OF THE DRAWINGS

FIG. 1 is a view showing the configuration of a system for monitoring a state of a power facility related to the present invention.

FIG. 2 is a block diagram showing the measurement device of FIG. 1.

FIG. 3 is a block diagram showing the power facility state monitoring device of FIG. 1.

FIG. 4 is a flowchart illustrating a method of calculating line parameters of a power facility state monitoring device according to an embodiment of the present invention.

FIG. 5 is a view showing input and output terminals (of three phases) of a power facility related to the present invention.

FIG. 6 is a view showing an equivalent circuit (of a single phase) of a short distance facility related to the present invention.

FIG. 7 is a view showing an equivalent circuit (of a single phase) of a middle distance facility related to the present invention.

FIG. 8 is a view showing a four-terminal network related to the present invention.

FIG. 9 is a view showing an equivalent circuit of a long distance facility related to the present invention.

FIG. 10 is a view showing a pi-equivalent circuit of a long distance facility (line) related to the present invention.

## DESCRIPTION OF SYMBOLS

1: Current Transformer
2: Potential Transformer
10: Measurement device
20: Power facility state monitoring device
30: HMI

## BEST MODE FOR CARRYING OUT THE INVENTION

A system for monitoring a state of a power facility by measuring line parameters (circuit parameters) on-line according to the present invention will be hereafter described in detail, with reference to the accompanying drawings.

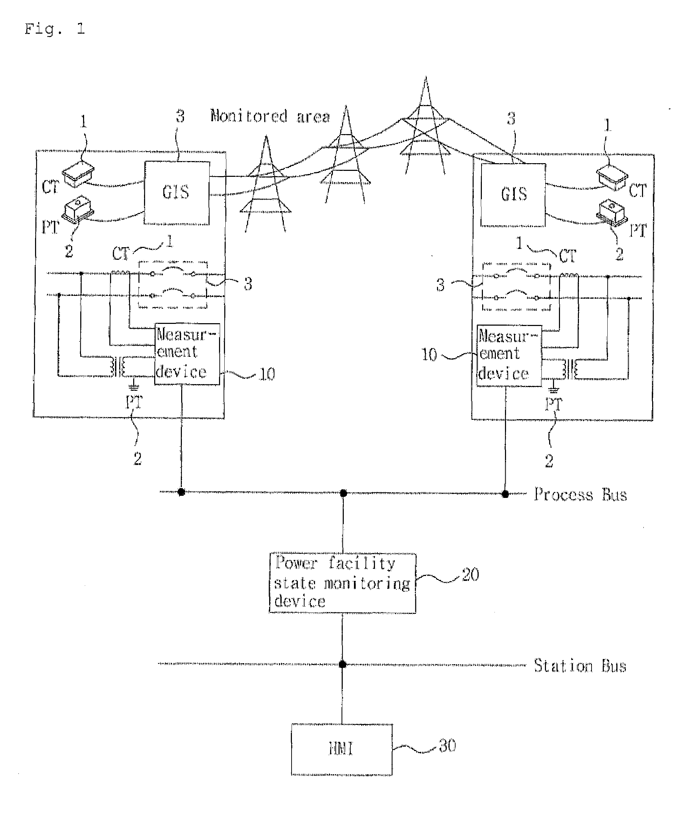

FIG. 1 is a view showing the configuration of a system for monitoring a state of a power facility related to the present invention.

The system for monitoring a state of a power facility includes a measurement device 10 for simultaneously measuring three-phase current and voltage at both ends of a monitored area of a transmission line, a power facility state monitoring device 20 for calculating line parameters using measurement data measured through the measurement device 10, and a human machine interface (HMI) 30 for receiving the line parameters from the power facility state monitoring device 20, storing the line parameters in a database, and determining and monitoring a state of the power facility by monitoring the state by time and by season based on the received line parameters.

These devices use a communication program manufactured to meet the information communication (IT) specification of a digital substation to which the units are installed and applied. An information communication network of a substation is configured of a process bus, which is a communication medium between the measurement device 10 and the power facility state monitoring device 20, and a station bus, which is a communication medium between the power facility state monitoring device 20 and the HMI 30.

The measurement device 10 transmits measurement data input from a current transformer (CT) 1 and a potential transformer (PT) 2 installed in a plurality of points to the power facility state monitoring device 20 through an Ethernet network. The current transformer 1 and the potential transformer 2 are installed at both ends of a power facility to be monitored and measure current and voltage flowing through the power facility. In addition, a gas insulated switchgear (GIS) 3 configured of a circuit breaker, a disconnecting switch and the like exists at both ends of the power facility to be monitored.

The power facility state monitoring device 20 receives three-phase voltage and current as sample value signals from the measurement device 10, calculates line parameters of each facility through four-terminal line parameter calculation using data of the same measurement time among the three-phase voltage and current, and stores the line parameters in memory. In addition, the power facility state monitoring device 20 transmits the line parameters stored in the memory to the HMI 30 as sample value signals through a communication protocol of the substation.

The power facility state monitoring device 20 monitors and controls the power facility by determining abnormality based on whether or not an increase and decrease rate of the calculated line parameter is out of a predetermined reference value and outputting an alarm, a state notification message or a trip signal. The power facility state monitoring device 20 transmits state information of the power facility to the HMI 30. The state information of the power facility includes an open/close state of the circuit breaker.

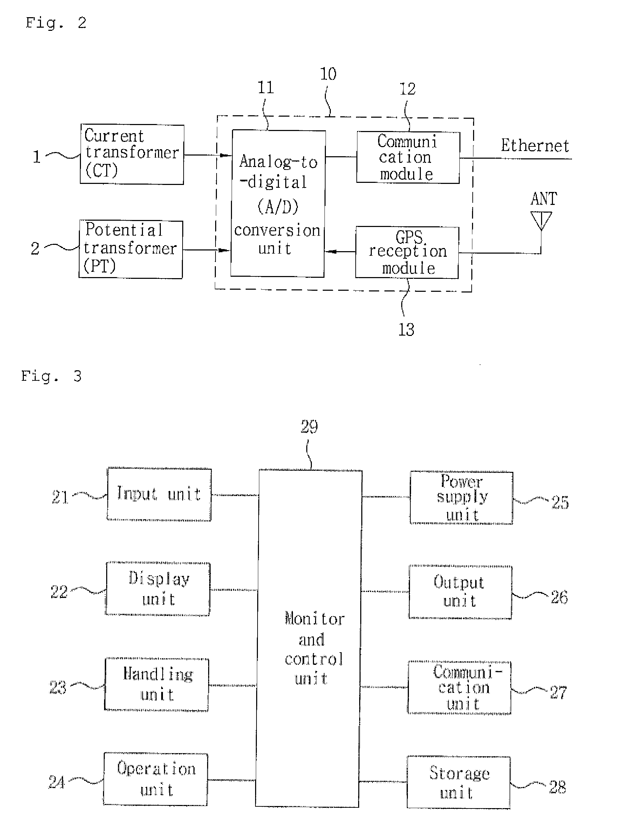

FIG. 2 is a block diagram showing the measurement device 10 of FIG. 1.

Referring to FIG. 2, the measurement device 10 includes an analog-to-digital (A/D) conversion unit 11, a communication module 12 and a global positioning system (GPS) reception module 13.

The A/D conversion unit 11 converts the measurement data (a current value and a voltage value) output from the current transformer 1 measuring current of the power facility and the potential transformer 2 measuring voltage of the power facility into digital data by synchronizing the measurement data to a time synchronization signal.

The communication module 12 transmits the digital data output from the A/D conversion unit 11 to the power facility state monitoring device 20 as a sample value through the Ethernet.

The GPS reception module 13 receives international standard time information from a satellite through an antenna (ANT) and transmits the time information to the A/D conversion unit 11 in the form of a tag. The A/D conversion unit 11 uses the time information received from the GPS reception module 13 as the time synchronization signal and inserts the time information into the converted digital data as a tag when the measurement data is converted into the digital data.

FIG. 3 is a block diagram showing the power facility state monitoring device of FIG. 1.

The power facility state monitoring device 20 includes an input unit 21, a display unit 22, a handling unit 23, an operation unit 24, a power supply unit 25, an output unit 26, a communication unit 27, a storage unit 28 and a monitor and control unit 29.

The input unit 21 performs a function of receiving a data output from the measurement device 10 and may be configured of a photo coupler and an optic 100B-FX S (input of current and voltage data through LAN). Three-phase current and voltage values of the input and output terminals of the power facility and an open/close state of the circuit breaker are input.

The display unit 22 displays various kinds of information (set information, menus and the like) related to the operation of the power facility state monitoring device 20 and displays line parameters of a monitored area of the power facility. The display unit 22 may be implemented using a liquid crystal display (LCD), a light emitting diode (LED) or the like or implemented as a touch screen. When the display unit 22 is implemented as a touch screen, the display unit 22 may perform a function of an input device as well as a display device.

The handling unit 23 is configured of keys for selecting menus and setting data.

The operation unit 24 receives three-phase voltage and current values having the same time information from the measurement device 10 and calculates line parameters of a monitoring target facility through a line parameter calculation process. The line parameters include resistance R and inductance L, which are series impedance, and capacitance C and leakage conductance g, which are parallel admittance.

The operation unit 24 may be implemented in a digital signal processor. For example, the operation unit may be implemented in TMS320F28335.

The power supply unit 25 is implemented in an SMPS for supplying power to each of constitutional components configuring the power facility state monitoring device 20. For example, the power supply unit 25 receives DC 125V, which is a control power of a substation, as an input, converts DC 125V into DC 24V, which is an internal input power, and supplies the converted power as an internal power.

The output unit 26 is configured as an internal relay and outputs an alarm, a message and a trip signal.

The communication unit 27 is a Linux-based MCU of an ARM series which implements a communication protocol such as IEC61850 and IEC61970, receives a sample value including a time tag attached according to the implemented communication protocol, and outputs the line parameters calculated by the operation unit 24.

The storage unit 28 stores data values of the monitor and control unit 29, the operation unit 24 and the communication unit 27 and shares internal communication.

The monitor and control unit 29 monitors and controls operation of the constitutional components described above.

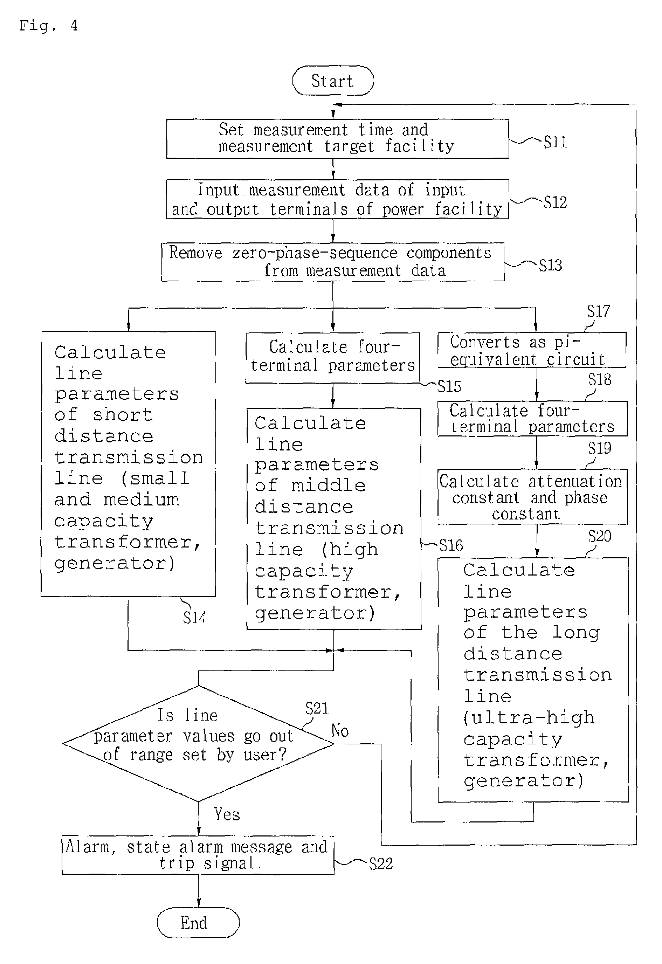

FIG. 4 is a flowchart illustrating a method of calculating line parameters of a power facility state monitoring device according to an embodiment of the present invention.

Referring to FIG. 4, the monitor and control unit 29 sets a measurement time (second, minute and hour) of three-phase voltage and current values according to handling of a user on the handling unit and selects a line parameter measurement target facility S11. Here, the measurement target facility includes a short distance facility, a middle distance facility and a long distance facility.

Next, the monitor and control unit 29 receives three-phase current and voltage values of both ends (input terminal and output terminal) of a plurality of points through a communication with the measurement device 10 and inputs the three-phase current and voltage values into the operation unit 24 S12. At this point, the monitor and control unit 29 confirms the time tag of the measurement data and accesses a measurement data corresponding to the set time tag.

The operation unit 24 removes zero-phase-sequence components from the measurement data under the control of the monitor and control unit S13. Here, the operation unit 24 calculates current and voltage of the zero-phase-sequence components from the measurement data and removes the current and voltage of the zero-phase-sequence components calculated from the measurement data.

When the measurement target facility is a short distance facility, the operation unit 24 calculates resistance and inductance (series impedance) among the line parameters using the measurement data S14.

On the other hand, when the measurement target facility is a middle distance facility, the operation unit 24 calculates four-terminal parameters S15 and calculates line parameters of the middle distance facility including resistance R, inductance L, capacitance C and leakage conductance g through the calculated four-terminal parameters S16.

On the other hand, when the measurement target facility is a long distance facility, the operation unit 24 converts the facility into a pi-equivalent circuit and calculates four-terminal parameters S17 and S18. Then, the operation unit 24 calculates an attenuation constant and a phase constant and calculates line parameters of the long distance facility S19 and S20.

The monitor and control unit 29 confirms whether or not the calculated line parameter values go out of a range set by the user S21.

If the calculated line parameter values go out of the range set by the user, the monitor and control unit 29 outputs an alarm and a state alarm message and controls operation of the circuit breaker by outputting a trip signal S22.

Hereinafter, a method of calculating the line parameters will be described in detail.

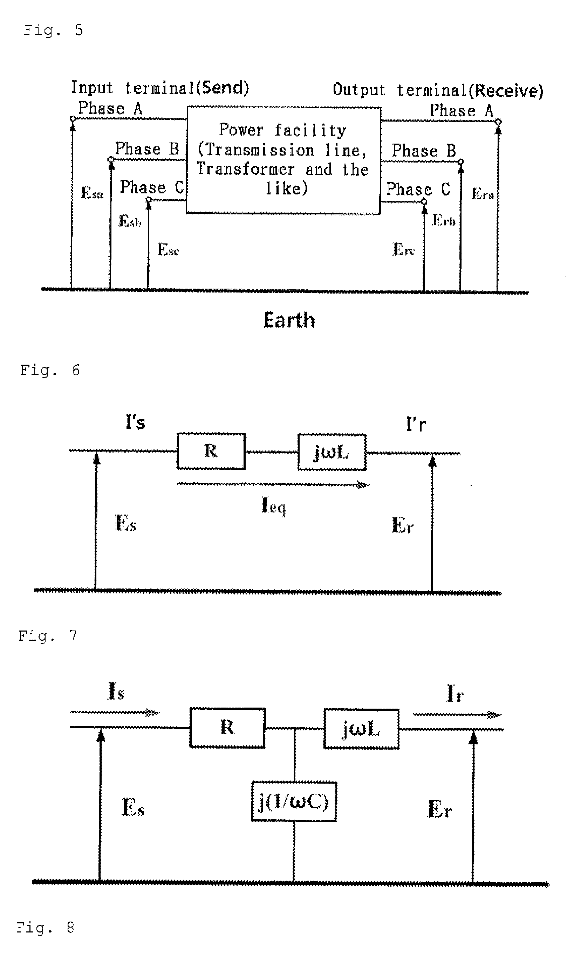

First, as shown in FIG. 5, the measurement device 10 measures voltage and current values of each phase at the input and output terminals of the power facility at the same time. The operation unit 24 of the power facility state monitoring device 20 calculates a complex number of each phase or a phasor value of another type from the voltage and current values measured by the measurement device 10 under the control of the monitor and control unit 29.

The voltages of the input and output terminals measured at each phase are expressed as shown in mathematical expression 1.

【Mathematical expression 1】

$$E_{sa} = E_{sa}^{r} + jE_{sa}^{i}$$

$$E_{sb} = E_{sb}^{r} + jE_{sb}^{i}$$

$$E_{sc} = E_{sc}^{r} + jE_{sc}^{i}$$

$$E_{ra} = E_{ra}^{r} + jE_{ra}^{i}$$

$$E_{rb} = E_{rb}^{r} + jE_{rb}^{i}$$

$$E_{rc} = E_{rc}^{r} + jE_{rc}^{i}$$

Here, $E_{sa}$, $E_{sb}$ and $E_{sc}$ are values calculated after measuring voltages of phase A, phase B and phase C at the input terminal, and $E_{ra}$, $E_{rb}$ and $E_{rc}$ are values calculated after measuring voltages of phase A, phase B and phase C at the output terminal. Here, superscript 'r' denotes a real part, and superscript 'i' denotes an imaginary part.

That is, the operation unit 24 calculates zero-phase-sequence voltage $E_{so}$ of a sending end, zero-phase-sequence current $I_{so}$ of the sending end, zero-phase-sequence voltage $E_{ro}$ of a receiving end and zero-phase-sequence current $I_{ro}$ of the receiving end using mathematical expression 2.

【Mathematical expression 2】

$$E_{so} = \frac{1}{3}[E_{sa} + E_{sb} + E_{sc}]$$

$$I_{so} = \frac{1}{3}[I_{sa} + I_{sb} + I_{sc}]$$

$$E_{ro} = \frac{1}{3}[E_{ra} + E_{rb} + E_{rc}]$$

$$I_{ro} = \frac{1}{3}[I_{ra} + I_{rb} + I_{rc}]$$

If the current and voltage of the zero-phase-sequence component are calculated at each phase, the operation unit 24 performs a complex number subtraction by subtracting the zero-phase-sequence component obtained from mathematical expression 2 from the voltage and current of each phase calculated at the input and output terminals.

The phase voltages ($E'_{sa}$, $E'_{sb}$, $E'_{sc}$) and the phase currents ($I'_{sa}$, $I'_{sb}$, $I'_{sc}$) at the sending end and the phase voltages ($E'_{ra}$, $E'_{rb}$, $E'_{rc}$) and the phase currents ($I'_{ra}$, $I'_{rb}$, $I'_{rc}$) at the receiving end, from which the zero-phase-sequence components are removed, are expressed as shown in mathematical expression 3.

【Mathematical expression 3】

$$\acute{E}_{sa} = E_{sa} - E_{so}$$

$$\acute{E}_{sb} = E_{sb} - E_{so}$$

$$\acute{E}_{sc} = E_{sc} - E_{so}$$

$$\acute{I}_{sa} = I_{sa} - I_{so}$$

$$\acute{I}_{sb} = I_{sb} - I_{so}$$

$$\acute{I}_{sc} = I_{sc} - I_{so}$$

$$\acute{E}_{ra} = E_{ra} - E_{ro}$$

$$\acute{E}_{rb} = E_{rb} - E_{ro}$$

$$\acute{E}_{rc} = E_{rc} - E_{ro}$$

$$\acute{I}_{ra} = I_{ra} - I_{ro}$$

$$\acute{I}_{rb} = I_{rb} - I_{ro}$$

$$\acute{I}_{rc} = I_{rc} - I_{ro}$$

Next, a method of calculating line parameters will be described in detail for each measurement target power facility (for each type of transmission line).

When the transmission line is a short distance line or a short distance in which capacitance or leakage current can be ignored, an equivalent circuit of the short distance facility is expressed as shown in FIG. 6 on the basis of a certain phase and a neutral point, and in this case, the operation unit 24 calculates impedance between both ends using mathematical expression 4.

【Mathematical expression 4】

$$Z = \frac{E'_{sa} - E'_{ra}}{I_{cg}} = R + j\omega L$$

Actually, resistance R and reactance ωL, which are impedance values of each phase, may be implemented as shown in mathematical expression 5.

【Mathematical expression 5】

$$Z_a = \frac{E'_{sa} - E'_{ra}}{I_{eq}} = R_a + j\omega L_a$$

$$Z_b = \frac{E'_{sb} - E'_{rb}}{I_{eq}} = R_b + j\omega L_b$$

$$Z_c = \frac{E'_{sc} - E'_{rc}}{I_{eq}} = R_c + j\omega L_c$$

In the case of a short distance facility, since $I_{eq}$ is actually a case of $I'_s = I'_r$ in mathematical expression 5, it can be calculated as $I_{eq} = I'_s$ or $I_{eq} = I'_r$.

Next, in the case of a middle distance facility corresponding to an ultra-high voltage short distance line less than 150Km and an extra-high voltage middle and long distance line (in the case where there is capacitance), an equivalent circuit is expressed as shown in FIG. 7 on the basis of a certain phase, and a four-terminal network is as shown in FIG. 8.

The operation unit 24 calculates four-terminal parameters in a procedure shown below.

A relation between voltage and current of an input terminal and voltage and current of an output terminal in the four-terminal network is expressed in the equations as shown in mathematical expression 6.

【Mathematical expression 6】

$$E_s = A E_r + B I_r$$
$$I_s = C E_r + D I_r$$

Here, A, B, C and D denote four-terminal line parameters, and A and D are simple proportional constants without a dimension, and B is resistance or impedance of a circuit, which is a constant having a unit of Ohm. In addition, C is admittance of a circuit, which is a constant having a unit of Mho.

Since mathematical expression 6 has four unknowns (A, B, C and D), at least four equations are required, and thus values of voltage and current $E_s$, $E_r$, $I_s$, and $I_r$ should be measures at least two or more times at different input and output terminals.

Accordingly, since four equations are established from two sets of voltage and current at the input and output terminals, the four unknowns (A, B, C and D) may be calculated.

However, if the measurement is repeated while the power facility in a similar driving state, a solution of the equation cannot be obtained since the equation established based on the measured values is similar to an existing one, and thus one of the two methods described below is selected and processed to automatically execute this process. In a first method, an equation is set up using the measured values, and a solution of the four-terminal line parameters A, B, C and D is obtained, and if the solution cannot be obtained since the former and latter equations are similar to each other, the monitor and control unit 29 displays a message saying that "A solution is not obtained" on a message display unit 12. Then, an equation is set up again using voltage and current measured next time, and this is repeated until a solution is obtained.

In a second method, the newly measured values of voltages and currents $E_s$, $E_r$, $I_s$, and $I_r$ of the input and output terminals are compared with previously measured and stored values, and then two sets of equations shown in FIG. 6 are set up, and a solution of the four-terminal line parameters A, B, C and D is obtained using the newly measured voltages and currents of the input and output terminals only when any one or more of the four values are changed more than a predetermined value (e.g., 20%).

The equations (set) established for phase A in such a manner are as shown in mathematical expression 7.

【Mathematical expression 7】

$$E'_{sa^1} = A E'_{ra^1} + B I'_{ra^1}$$

$$I'_{sa^1} = C E'_{ra^1} + D I'_{ra^1}$$

$$E'_{sa^2} = A E'_{ra^2} + B I'_{ra^2}$$

$$I'_{sa^2} = C E'_{ra^2} + D I'_{ra^2}$$

Here, the superscript '1' denotes a previously measured value, and the superscript '2' denotes a value measured later. All the voltages and currents $E_s$, $E_r$, $I_s$, and $I_r$ of each phase and the line parameters A, B, C and D used in mathematical expression 7 are complex numbers (real value + j imaginary value).

As described above, in the case of a middle distance line, B among the line parameters A, B, C and D analyzed in the equations is impedance, and C is admittance. Accordingly, line parameters R, L, g and C may be obtained by calculating as shown in mathematical expression 8.

【Mathematical expression 8】

$$B = Z = R + j\omega L$$
$$C = Y = g + j\omega C$$

Here, g denotes leakage conductance.

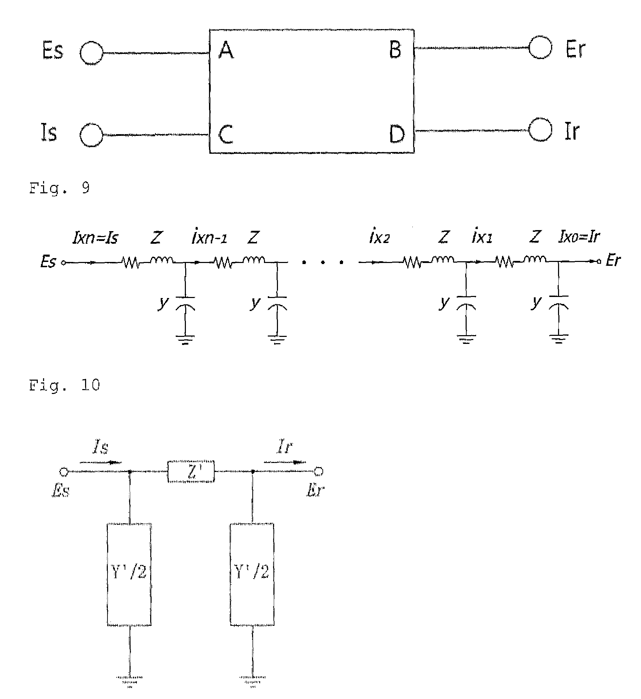

Finally, in the case of an ultra-high voltage line of 150Km or longer and a long distance facility having high capacitance and distributed across the entire section, it can be converted into an equivalent circuit as shown in FIG. 9 and expressed as a distribution constant circuit on the basis of a certain phase.

At this point, four-terminal network equations are as shown in mathematical expression 9.

【Mathematical expression 9】

$$E_s = \cosh\gamma l E_r + Z_\omega \sinh\gamma l I_r$$

$$I_s = \frac{1}{Z_\omega}\sinh\gamma l E_r + \cosh\gamma l I_r$$

Here, $Z_\omega$ denotes characteristic impedance or wave impedance and is expressed as shown in mathematical expression 10.

【Mathematical expression 10】

$$Z_\omega = \sqrt{\frac{z}{y}} = \sqrt{\frac{r+jx}{g+jb}}$$

Here, z denotes impedance per unit length, *y* denotes admittance per unit length, and r denotes a propagation constant. The propagation constant is expressed as shown in mathematical expression 11.

【Mathematical expression 11】

$$\gamma = \sqrt{zy} = \sqrt{(r+jx)(g+jb)}$$

Here, *l* denotes the length of a line.

In this case, a long distance line can be converted as a pi(n)-equivalent circuit as shown in FIG. 10. Although the pi-equivalent circuit is the same as an existing pi-equivalent circuit, it is different in that Z' and Y'/2 are used instead of Z and Y.

A relation as shown in FIG. 12 can be used from the pi-equivalent circuit, and the relation can be applied in calculating an impedance value of a long distance transmission line.

【Mathematical expression 12】

$$E_s = \cosh\gamma l\, E_r + Z' I_r$$

$$I_s = Y'(1+\frac{Z'Y'}{4})E_r + \cosh\gamma l\, I_r$$

Here, since $\cosh\gamma l$ is the same as A of the pi-equivalent circuit and parameter B is Z' of the pi-equivalent circuit in mathematical expression 9, $B = Z' = Z\dfrac{\sinh\gamma l}{\gamma l}$ .

A process of calculating Z is described.

Four-terminal line parameters A, B, C and D are calculated from two sets of equations shown in mathematical expression 12, and Z is obtained from B. Here, Z desired to be calculated is as shown in mathematical expression 13.

【Mathematical expression 13】

$$Z = B\frac{\gamma l}{\sinh\gamma l}$$

Here, $\gamma l$ is $\alpha+j\beta$, and $\alpha$ denotes an attenuation constant, and $\beta$ denotes a phase constant.

Since A of the four-terminal line parameters is the same as $\cosh\gamma l = \cosh(\alpha+j\beta)$, it is that $\cosh(\alpha+j\beta)=A_r+jA_r$ as shown in mathematical expression 14.

【Mathematical expression 14】

$$A_r + jA_i = \frac{1}{2}[\epsilon^\alpha\cos\beta + \epsilon^{-\alpha}\cos\beta] + j\frac{1}{2}[\epsilon^\alpha\sin\beta + \epsilon^{-\alpha}\sin\beta]$$

Here, since $A_r = \dfrac{1}{2}[\epsilon^\alpha\cos\beta + \epsilon^{-\alpha}\cos\beta]$, it can be expressed as $\epsilon^\alpha = \dfrac{2A_r}{\cos\beta} - \epsilon^{-\alpha}$ in terms of $\epsilon^\alpha$.

If $\epsilon^\alpha = \dfrac{2A_r}{\cos\beta} - \epsilon^{-\alpha}$ is put into $A_i = \dfrac{1}{2}[\epsilon^\alpha\sin\beta + \epsilon^{-\alpha}\sin\beta]$, it can be expressed as shown in mathematical expression 15.

【Mathematical expression 15】

$$\epsilon^{-\alpha} = \frac{-A_i}{\sin\beta} + \frac{A_r}{\cos\beta} = \frac{A_r\sin\beta - A_i\cos\beta}{\sin\beta\cos\beta}$$

If $A_r = \frac{1}{2}[\epsilon^\alpha\cos\beta + \epsilon^{-\alpha}\cos\beta]$ of mathematical expression 15 is expressed in terms of $\epsilon^\alpha$, it can be expressed as shown in mathematical expression 16.

【Mathematical expression 16】

$$\epsilon^\alpha = \frac{A_r\sin\beta + A_i\cos\beta}{\sin\beta\cos\beta}$$

If mathematical expression 15 and mathematical expression 16 are multiplied, it is as shown in mathematical expression 17, and this can be developed as shown in mathematical expression 18.

【Mathematical expression 17】

$$1 = \frac{A_r^2}{\cos^2\beta} - \frac{A_i^2}{\sin^2\beta}$$

【Mathematical expression 18】

$$\sin^4\beta + (A_r^2 + A_i^2 - 1)\sin^2\beta - A_i^2 = 0$$

If it is assumed that $X = \sin^2\beta$, mathematical expression 18 becomes a second order equation as shown in mathematical expression 19.

【Mathematical expression 19】

$$X^2 + (A_r^2 + A_i^2 - 1)X - A_i^2 = 0$$

This equation can be calculated in a general method, and β is obtained as shown in mathematical expression 20 from the obtained X.

【Mathematical expression 20】

$$\beta = \sin^{-1}\sqrt{X}$$

Here, although β may have two solutions of positive (+) and negative (-), since a negative value does not exist physically, only the positive value is adopted.

α is obtained by putting the obtained β value into mathematical expression 16, and subsequently, $\gamma l = \alpha + j\beta$ is obtained. Finally, line impedance Z is obtained by putting $Z = B \dfrac{\gamma l}{\sinh \gamma l}$ , and since *Z=R+jωL,* resistance R and inductance ωL of the circuit are obtained.

Next, since $C = Y'(1 + \dfrac{Z'Y'}{4})$ in mathematical expression 12, Y($\dot{Y}$) is calculated using the calculated B and C values and the previously obtained Z value.

Finally, line admittance Y may be obtained by using $Y = \dfrac{Y'}{2} (Y' = \dfrac{Y}{2})$ .

Accordingly, leakage conductance g and capacitance ωC are obtained from Y=g+jωC.

Power facilities such as a transformer, a generator and the like, not a transmission line, will be described.

Line parameters are measured using mathematical expression 5 for a small capacity facility less than some tens of thousands of KVA, like a short distance transmission line, and in the case of a power facility of some hundreds of thousands of KVA, a measurement method using a four-terminal network circuit as shown in mathematical expression 6 can be used, like a middle distance transmission line.

In the case of a power facility higher than a million KVA class, the process after mathematical expression 9 can be applied, like a long distance transmission line.

Particularly, in the case of a superconducting power facility (a cable, a fault current limiter, a transformer, a generator or the like), a state monitoring and protecting function can be provided for a quenching phenomenon generated when a superconducting state cannot be maintained.

While the present invention has been described with reference to the particular illustrative embodiments, it is not to be restricted by the embodiments but only by the appended claims. It is to be appreciated that those skilled in the art can change or modify the embodiments without departing from the scope and spirit of the present invention.

**Claims**

1. A system for monitoring a state of a power facility using line parameters, the system comprising:

   a measurement device including an analog-to-digital (A/D) converter for converting current and voltage of the power facility measured through a current transformer (CT) and a potential transformer (PT) into digital signals by synchronizing the current and voltage to a time synchronization signal, a global positioning system (GPS) module for providing the A/D converter with the time synchronization signal, and a communication module for transmitting the signals output from the A/D converter through Ethernet;
   a power facility state monitoring device including an input unit for inputting measurement data transmitted through the communication module, an operation unit for calculating line parameters of a measurement target facility using the measurement data input through the input unit, a communication unit for transmitting the calculated line parameters according to a certain communication specification, and a monitor and control unit for monitoring and controlling the power facility by controlling operation of the input unit, the operation unit and the communication unit, determining whether or not the power facility is abnormal according to whether or not a magnitude or an increase or decrease rate of the calculated line parameters goes out of a predetermined reference value, and outputting an alarm, a state alarm message or a trip signal; and
   a human machine interface (HMI) for estimating a state of the power facility using the line parameters provided from the power facility state monitoring device.

2. The system according to claim 1, wherein the communication specification is a communication protocol such as IEC61850 and IEC61970 used at a digital substation.

3. The system according to claim 1, wherein the line parameters include resistance, inductance, capacitance and leakage conductance.

4. The system according to claim 1, wherein the operation unit calculates an zero-phase-sequence component of the measurement data and removes the zero-phase-sequence component by subtracting the calculated zero-phase-sequence component from the measurement data.

5. A method of monitoring a state of a power facility on-line by measuring line parameters, the method comprising the steps of:

setting a measurement time and selecting a measurement target facility according to an external input;
inputting current and voltage data measured at the selected measurement target facility;
extracting current and voltage data corresponding to the set measurement time with reference to time information tagged on the input current and voltage data;
removing an zero-phase-sequence component from the extracted current and voltage data;
calculating the line parameters of the selected measurement target facility using the current and voltage data from which the zero-phase-sequence component is removed; and
determining existence of a failure or abnormality according to whether or not a magnitude or an increase or decrease rate of the calculated line parameters goes out of a predetermined reference value, and outputting an alarm, a state alarm message or a trip signal.

6. The method according to claim 5, wherein the measurement target facility includes a short distance facility, a middle distance facility and a long distance facility.

7. The method according to claim 5, wherein the time information is received through GPS reception when the current and voltage data are measured.

8. The method according to claim 5, wherein the line parameter calculation step calculates resistance and inductance among the line parameters when the measurement target facility is a short distance transmission line or a small and medium capacity power facility.

9. The method according to claim 6, wherein the line parameter calculation step calculates resistance, inductance, capacitance and leakage conductance, which are the line parameters, through four-terminal line parameter calculation when the measurement target facility is a middle distance transmission line or a high capacity power facility.

10. The method according to claim 6, wherein the line parameter calculation step calculates four-terminal parameters, an attenuation constant and a phase constant by converting the measurement target facility into a pi-equivalent circuit when the measurement target facility is a long distance transmission line or a ultra-high capacity power facility higher than a million KVA class and calculates line parameters of the long distance transmission line using the calculated four-terminal parameters, attenuation constant and phase constant.

Fig. 1

Fig. 2

```
        11        10        12
                           Communi-
  Current           ┌──────┐ cation
1 transformer ──→   │Analog-to│ module ──→ Ethernet
  (CT)              │-digital │
                    │ (A/D)   │
                    │conversion│        ANT
  Potential         │ unit    │ GPS      ▽
2 transformer ──→   │         │←── reception ──
  (PT)              └──────┘   module
                                 13
```

Fig. 3

```
21 ─ Input unit ─┐           ┌─ Power     ─ 25
                 │           │  supply
                 │           │  unit
22 ─ Display   ─┤  Monitor  ├─ Output    ─ 26
     unit        │   and     │  unit
                 │  control  │
23 ─ Handling  ─┤   unit    ├─ Communi-  ─ 27
     unit        │   29      │  cation
                 │           │  unit
24 ─ Operation ─┤           ├─ Storage   ─ 28
     unit        │           │  unit
```

Fig. 4

```
                          ( Start )
                              │
         ┌────────────────────────────────────────┐
         │     Set measurement time and           │──── S11
         │    measurement target facility         │
         └────────────────────────────────────────┘
                              │
         ┌────────────────────────────────────────┐
         │     Input measurement data of input    │──── S12
         │  and output terminals of power facility │
         └────────────────────────────────────────┘
                              │
         ┌────────────────────────────────────────┐
         │  Remove zero-phase-sequence components  │──── S13
         │       from measurement data            │
         └────────────────────────────────────────┘
```

S17

┌─────────────────┐   ┌─────────────────┐   ┌──────────────────────┐
│ Calculate       │   │ Calculate four- │   │ Converts as pi-      │
│ line            │   │ terminal        │   │ equivalent circuit   │
│ parameters      │   │ parameters      │   └──────────────────────┘
│ of short        │   └─────────────────┘─── S15         │  S18
│ distance        │   ┌─────────────────┐   ┌──────────────────────┐
│ transmission    │   │ Calculate       │   │ Calculate four-      │
│ line (small     │   │ line            │   │ terminal parameters  │
│ and medium      │   │ parameters      │   └──────────────────────┘
│ capacity        │   │ of middle       │            │  S19
│ transformer,    │   │ distance        │   ┌──────────────────────┐
│ generator)      │   │ transmission    │   │ Calculate attenuation│
└─────────────────┘   │ line (high      │── S16│ constant and phase   │
           S14        │ capacity        │   │     constant         │
                      │ transformer,    │   └──────────────────────┘
                      │ generator)      │            │  S20
                      └─────────────────┘   ┌──────────────────────┐
                                            │ Calculate            │
                                            │ line                 │
              ╱╲                            │ parameters           │
         ╱         ╲                        │ of the long          │
      ╱    Is line    ╲   S21               │ distance             │
     ╱ parameter values go out ╲─── No      │ transmission         │
      ╲  of range set by user? ╱            │ line                 │
         ╲              ╱                    │ (ultra-high          │
              ╲╱                            │ capacity             │
               │ Yes                        │ transformer,         │
         ┌──────────────────────────┐       │ generator)           │
         │ Alarm, state alarm message and│── S22 └──────────────────┘
         │       trip signal.        │
         └──────────────────────────┘
                    │
                ( End )
```

Fig. 5

Input terminal(Send)          Output terminal(Receive)
    Phase A                              Phase A

                ┌─────────────────────┐
    Phase B     │   Power facility    │    Phase B
                │ (Transmission line, │
    Esa         │  Transformer and the│    Era
    Phase C     │       like)         │    Phase C
                └─────────────────────┘
    Esb                                     Erb

        Esc                         Erc


                        Earth

Fig. 6

        I's                              I'r

                ┌─────┐      ┌─────┐
     ──────────┤  R  ├──────┤ jωL ├──────────
                └─────┘      └─────┘

                    ──────────────►
                          Ieq

        Es                               Er


Fig. 7

        Is                               Ir
     ═══════►                         ═══════►

                ┌─────┐      ┌─────┐
     ──────────┤  R  ├──┬───┤ jωL ├──────────
                └─────┘  │   └─────┘
                      ┌──┴──────┐
                      │ j(1/ωC) │
                      └──┬──────┘
        Es               │                Er


Fig. 8

Es ◯ ——————— A          B ——————— ◯ Er

Is ◯ ——————— C          D ——————— ◯ Ir

Fig. 9

$Ixn=Is$   $Z$   $ix_{n-1}$   $Z$          $ix_2$   $Z$   $ix_1$   $Z$   $Ix_0=Ir$

Es ○———W—m———→—W—m——— ⋅ ⋅ ⋅ ———→—W—m———→—W—m———○ Er

          $y$        $y$                    $y$        $y$

Fig. 10

$Is$                        $Ir$

Es                          Er

$Z'$

$Y'/2$        $Y'/2$

## INTERNATIONAL SEARCH REPORT

International application No.

**PCT/KR2012/007475**

| A. | CLASSIFICATION OF SUBJECT MATTER |
|---|---|

***G01R 31/08(2006.01)i, G01R 27/04(2006.01)i, G01R 27/32(2006.01)i***

According to International Patent Classification (IPC) or to both national classification and IPC

| B. | FIELDS SEARCHED |
|---|---|

Minimum documentation searched (classification system followed by classification symbols)
G01R 31/08; H04B 3/54; G01R 27/16; H02J 13/00; G06Q 50/06

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)

eKOMPASS (KIPO internal) & Keywords: "current transformer, transformer, CT, PT, power facility, electric current, voltage, timing synchronization signal, digital signal, conversion unit, communication module, measurement device, measured data, input portion, calculation unit, communication unit, line constant"

| C. | DOCUMENTS CONSIDERED TO BE RELEVANT | |
|---|---|---|
| Category* | Citation of document, with indication, where appropriate, of the relevant passages | Relevant to claim No. |
| A | KR 10-2010-0059065 A (HYUNDAI HEAVY INDUSTRIES CO., LTD.) 04 June 2010<br>Abstract, paragraphs [0007]-[0032], claims 1-3, figure 1 | 1-10 |
| A | KR 10-2011-0025488 A (HYUNDAI HEAVY INDUSTRIES CO., LTD.) 10 March 2011<br>Abstract, paragraphs [0006]-[0022], claims 1-3, figure 1 | 1-10 |
| A | JP 3317557 B2 (TOKYO ELECTRIC POWER CO. INC. AND TOSHIBA CORP.) 14 June 2002<br>Paragraphs [0006]-[0025], claims 1-2, figures 1-15 | 1-10 |

☐ Further documents are listed in the continuation of Box C.     ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 28 JANUARY 2013 (28.01.2013) | **06 FEBRUARY 2013 (06.02.2013)** |
| Name and mailing address of the ISA/KR<br>Korean Intellectual Property Office<br>Government Complex-Daejeon, 139 Seonsa-ro, Daejeon 302-701,<br>Republic of Korea<br>Facsimile No. 82-42-472-7140 | Authorized officer<br><br><br>Telephone No. |

Form PCT/ISA/210 (second sheet) (July 2009)

INTERNATIONAL SEARCH REPORT
Information on patent family members

International application No.

**PCT/KR2012/007475**

| Patent document cited in search report | Publication date | Patent family member | Publication date |
|---|---|---|---|
| KR 10-2010-0059065 A | 04.06.2010 | NONE | |
| KR 10-2011-0025488 A | 10.03.2011 | NONE | |
| JP 3317557 B2 | 14.06.2002 | JP 06-242158 A | 02.09.1994 |

Form PCT/ISA/210 (patent family annex) (July 2009)